# EUROPEAN PATENT APPLICATION

(11) **EP 0 795 967 A1**
(43) Date of publication of application: **17.09.1997**
(21) Application number: 97200687.8
(22) Date of filing: 07.03.1997
(51) Int. Cl.: H04B 1/16, H03G 3/30

(54) **Power saving method for radio receiver**

(30) Priority: 14.03.1996 EP 96301740
(71) Applicant: Philips Patentverwaltung GmbH, 22335 Hamburg (DE); Philips Electronics N.V., 5621 BA Eindhoven (NL)
(72) Inventor: Jansen, Winifried, Philips Patentverwaltung GmbH, 22335 Hamburg (DE)
(74) Representative: Moody, Colin James

(57) **Abstract**

A method of power conservation in a radio receiver in which the gain of the rf stage (12, 14) is controlled whenever the signal strength exceeds by a predetermined amount a value of sensitivity giving a certain bit error rate.

## Description

The present invention relates to improvements in or relating to radio receivers or receiving sections of radio transceivers which for ease of reference in the present specification will be included in the term "radio receivers". The present invention is directed more particularly to power conservation which is of particular interest in portable/mobile equipments such as radio pagers, digital cordless and cellular telephones and other types transportable equipments powered by batteries.

In a radio receiver a significant feature of the architecture which influences power consumption is the rf section. Because the radio receivers are transportable and their distances from transmitting antennas varies, the field strength of the wanted signal varies over a wide range. The signal to noise ratio varies with the changes in field strength. In the case of a digital signal transmission system, the sensitivity quoted is in terms of the required rf input power to achieve a predetermined bit error rate (BER) of, for example, 0.01.

It is customary for radio receivers to include an automatic gain control (agc) system which typically is designed to avoid non-linearities at large signal conditions due to unwanted large signals. These agc systems normally measure the amplitude of all signals and the results are used to reduce the gain of the rf amplifier under high gain conditions to avoid overloading the mixer or mixers which could lead to the generation of 3rd order intermodulation products which are greater than the wanted signals which are lost. However using agc systems in this way is not optimal from the point of view of power conservation because generally speaking the sensitivity is higher than is necessary when receiving digital signals.

An object of the present invention is to improve power conservation in radio receivers whilst avoiding the generation of 3rd order intermodulation products.

According to one aspect of the present invention there is provided a method of power conservation in a radio receiver in which the gain of an rf stage is controlled whenever the signal strength exceeds by a predetermined amount a value of sensitivity giving a certain bit error rate.

The first aspect of the present invention provides a method of conserving power in a radio receiver, comprising determining the minimum sensitivity value for a predetermined bit error rate, setting a predetermined sensitivity value which is greater than the said minimum sensitivity value, and, in response to the signal strength exceeding the said predetermined sensitivity value, applying gain control to an input stage of the radio receiver.

According to another aspect of the present invention there is provided a radio receiver comprising means for detecting an input rf signal, rf signal amplifying means coupled to said detecting means, means for determining the strength of the input rf signal, means for setting a threshold signal strength value which exceeds by a predetermined amount the minimum sensitivity value to give a predetermined bit error rate, and means responsive to the determined signal strength exceeding the threshold value for controlling the gain of the rf signal amplifying means.

The present invention is based on the realisation that if the input digital signal has a level which is say up to substantially 20dB, for example 15dB, higher than a specified sensitivity then the BER reaches the specified requirements of a complete system. In other words for all wanted signals having a level higher than say 15dB above the specified sensitivity then the output signal of the rf amplifier is higher than the minimum specified so that current is wasted amplifying such large input signals. However for lower amplitude input signals, the rf amplifier provides the desired higher amplification.

The present invention will now be described, by way of example, with reference to the accompanying drawings, wherein:
Figure 1 is a block schematic diagram of a zero IF receiver,
Figure 2 is a curve of wanted signal strength (WSS) versus BER,
Figure 3 is a curve of wanted signal strength versus agc voltage
Figure 4 is a curve of wanted signal strength versus current consumption, and
Figure 5 is a flow chart of the agc process.

In the drawings the same reference numerals have been used to indicate corresponding features.

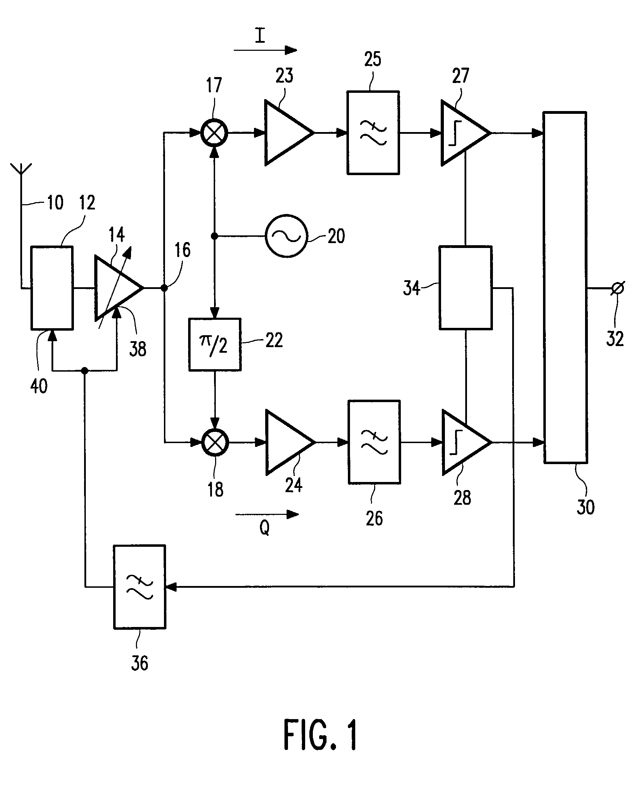

The zero IF radio receiver shown in Figure 1 comprises an antenna 10 which is coupled by way of a PIN diode attenuator 12 to a rf amplifier 14, the gain of which is adjustable. The output of the rf amplifier 14 is split at a signal dividing node 16 and the portions of the input signal are applied to quadrature related signal paths I and Q. More particularly the signal portions are applied to first inputs of mixers 17, 18. A local oscillator 20 having a frequency corresponding substantially to the notional carrier frequency of the wanted signal received at the antenna 10 is coupled to a second input of the mixer 17 and, by way of a 90 degree phase shifter 22, to a second input of the mixer 18. The outputs of the mixers 17, 18 which are in phase quadrature, are applied to respective post-mixer amplifiers 23, 24. Low pass filters 25, 26 select the difference signal from the products of mixing which are present at the respective outputs of the amplifiers 23, 24. Limiting amplifiers 27, 28 have inputs coupled to outputs of the low pass filters 25, 26, respectively, and outputs coupled to a demodulator 30 which has an output 32.

A signal amplitude measuring circuit 34 is coupled to the limiting amplifiers 27, 28. The circuit 34 provides an output signal indicative of the amplitude of the received signal. An output of the circuit 34 is connected to a low pass, loop filter 36 which applies gain control signals as required to a control input 38 of the rf amplifier 14 and to a control input 40 of the PIN diode attenuator 12.

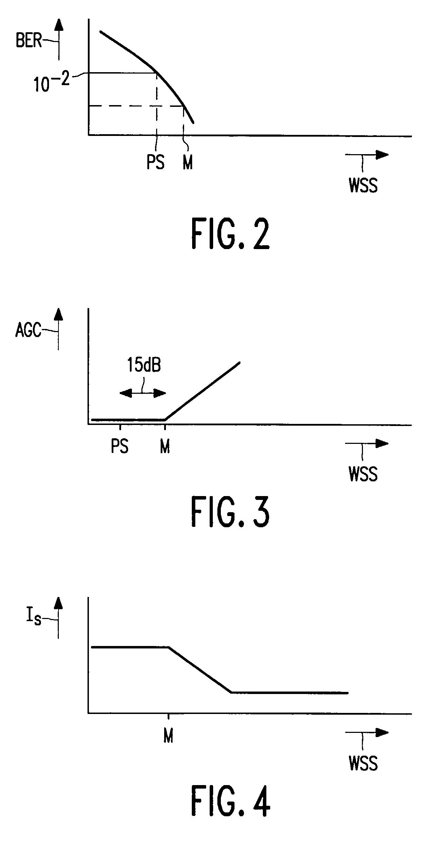

Figure 2 is a graph of wanted signal strength WSS plotted against BER which shows that the bit error rate diminishes as the wanted signal strength increases. In accordance with the present invention the BER rate of the receiver is specified and the corresponding sensitivity PS is determined for example by pre-calculation, then a safety margin M of the receiver sensitivity is specified, say 15dB higher than that determined to give the specified BER, and the gain control of the rf amplifier 14 and/or the PIN diode attenuator 12 is arranged to maintain this 15dB margin, preference being given to reducing the gain of the amplifier 14. As a result of this approach to gain control, the current consumption of the rf stage of the receiver can be reduced whilst keeping the BER within a certain range and also third order intermodulation distortion is avoided.

Figure 3 is a graph illustrating wanted signal strength WSS versus gain control voltage AGC. At a predetermined point on the abscissa the receiver sensitivity for a specified BER has been referenced PS. A 15dB margin M is shown after which the gain control voltage increases to reduce the gain of the rf amplifier 14 and/or increase the attenuation applied by the PIN diode attenuator 12.

Figure 4 illustrates wanted signal strength WSS plotted against current consumption Iₛ and shows that at the point M the current consumption reduces to a minimum value as the gain control voltage increases.

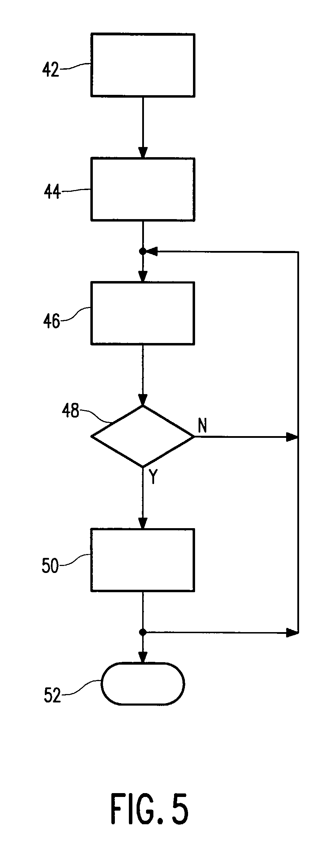

Figure 5 is a simplified flow charge illustrating the method in accordance with the present invention.

In block 42 the signal strength for a predetermined BER is specified. In block 44 the value of the signal strength is preset at a predetermined higher value, say 15dB higher. In block 46 the transmitted signal is received and its signal strength, say RSSI, is measured. In block 48 a check is made to see if the measured signal strength exceeds the 15dB value. If the answer is no(N), the process reverts to the block 46. Alternatively if the answer is yes(Y), then in block 50 the gain of the rf amplifier 14 and/or the attenuation of the PIN diode attenuator is adjusted. The flow chart reverts to the block 46 unless the process is ended as indicated by a block 52.

Although a zero IF receiver has been illustrated in, and described with reference to, Figure 1 it is to be understood that the present invention is applicable to superheterodyne receivers as well.

From reading the present disclosure, other modifications will be apparent to persons skilled in the art. Such modifications may involve other features which are already known in the design, manufacture and use of radio receivers and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A method of power conservation in a radio receiver in which the gain of an rf stage is controlled whenever the signal strength exceeds by a predetermined amount a value of sensitivity giving a certain bit error rate.

2. A method of conserving power in a radio receiver, comprising determining the minimum sensitivity value for a predetermined bit error rate, setting a predetermined sensitivity value which is greater than the said minimum sensitivity value, and, in response to the signal strength exceeding the said predetermined sensitivity value, applying gain control to an input stage of the radio receiver.

3. A method as claimed in claim 2, characterised in that the predetermined sensitivity value is set at a value up to substantially 20dB greater than the said minimum value.

4. A method as claimed in claim 2, characterised in that the predetermined sensitivity value is set substantially 15dB greater than the said minimum value.

5. A radio receiver comprising means for detecting an input rf signal, rf signal amplifying means coupled to said detecting means, means for determining the strength of the input rf signal, means for setting a threshold signal strength value which exceeds by a predetermined amount the minimum sensitivity value to give a predetermined bit error rate, and means responsive to the determined signal strength exceeding the threshold value for controlling the gain of the rf signal amplifying means.

6. A receiver as claimed in claim 5, characterised in that the threshold signal strength value is set at a value up to substantially 20dB greater than the minimum sensitivity value.

7. A receiver as claimed in claim 5, characterised in that the threshold signal strength value is set substantially 15dB greater than the minimum sensitivity value.

8. A receiver as claimed in claim 5, characterised by amplitude limiting means coupled to a signal input of the rf signal amplifying means.

9. A receiver as claimed in claim 5, characterised by variable signal attenuating means coupled to a signal input of the rf signal amplifying means, the degree of attenuation of the variable signal attenuating means being determined by the gain control means.

10. A receiver as claimed in claim 9, characterised in that the variable signal attenuating means comprises a PIN diode.
